# FASCICULE DE BREVET EUROPEEN

(11) **EP 1 672 696 B1**
(45) Date de publication et mention de la délivrance du brevet: **14.09.2011**
(21) Numéro de dépôt: 05300994.0
(22) Date de dépôt: 02.12.2005
(51) Int. Cl.: H01L 27/144

(54) **Dispositif à semi-conducteur de détection multi-spectrale d'un rayonnement électromagnétique et procédé de mise en oeuvre d'un tel dispositif**
Halbleiterbauelement zur multi-spektralen Detektion von Strahlung und Verwendung des Halbleiterbauelements
Semiconductor device to detect multi-spectral radiaton and method of using the device

(30) Priorité: 17.12.2004 FR 0453034
(43) Date de publication de la demande: 21.06.2006
(73) Titulaire: Commissariat à l'Énergie Atomique et aux Énergies Alternatives, 75015 Paris (FR)
(72) Inventeur: Rothman, Johan, 38000 Grenoble (FR)
(74) Mandataire: Vuillermoz, Bruno

(56) Documents cités:
- US-A- 4 119 994
- US-A- 4 390 889
- US-A1- 2002 011 640
- US-A1- 2004 036 093
- US-B1- 6 803 557

## Description

### DOMAINE TECHNIQUE

L'invention concerne en premier lieu un photodétecteur à semi-conducteur, constitué d'une ou de plusieurs diodes à hétérojonctions multiples.

L'invention vise également la mise en oeuvre de tels photodétecteurs dans le cadre de la réalisation d'un dispositif de détection multispectral d'un rayonnement électromagnétique, c'est à dire d'un dispositif susceptible de détecter simultanément plusieurs longueurs d'onde ou plusieurs bandes de longueurs d'onde d'un rayonnement électromagnétique.

### ETAT ANTERIEUR DE LA TECHNIQUE

Un photodétecteur selon l'invention vise à présenter une sensibilité simultanée à au moins deux bandes spectrales, c'est à dire de longueurs d'onde ou bandes de longueurs d'onde différentes. Un dispositif de détection mettant en oeuvre de tels détecteurs présente un certain nombre d'applications, notamment la formation d'images, s'agissant du domaine infrarouge.

Dans le cadre de la détection de rayonnements électromagnétiques, et notamment infrarouge, il est connu de mettre en oeuvre des photodétecteurs à semi-conducteur, et notamment des diodes à hétérojonctions multiples. De telles diodes sont constituées d'une structure empilée de couches de matériau semi-conducteur, présentant au moins deux interfaces, localisées au niveau ou dans la proximité d'une jonction p-n.

Une jonction p-n est constituée, de manière connue, d'un dispositif semi-conducteur, dont une partie a été dopée n et l'autre a été dopée p, les deux parties étant séparées par un plan dit « de jonction ».

La mise en oeuvre comme matériau semi-conducteur d'un élément photodétecteur induit de manière connue, lorsque le matériau reçoit un rayonnement incident d'énergie suffisante, donc de longueur d'onde déterminée inférieure à une valeur représentative de l'énergie correspondant à la largeur de la bande interdite, l'émission de conducteurs électriques de type électrons ou trous, susceptibles alors d'être collectés par un circuit électrique de lecture.

Le principe de la mise en oeuvre de diodes à hétérojonctions multiples est connu. Parmi celle-ci, l'exemple le plus courant est la diode p-i-n, caractérisée par la présence d'une couche intermédiaire de dopage intrinsèque, ou proche de l'intrinsèque, entre des couches de matériaux respectivement dopées n et p, et sans variation de la largeur de la bande interdite.

De telles diodes sont principalement mises en oeuvre pour la photodétection rapide, car elles permettent une évacuation rapide des photoporteurs générés dans le matériau de la couche intermédiaire de type i. Traditionnellement, la couche intermédiaire réalisée en matériau de type i est plus épaisse que les deux couches respectivement de dopage de type n et p, de sorte que la majorité des photoporteurs est donc générée dans ledit matériau de type intrinsèque i. Ce faisant, la diode est certes plus rapide, mais le rendement quantique est faible. Par ailleurs, la mise en oeuvre est plus complexe.

On a également proposé, par exemple dans la publication « High UV/solar rejection ratios in GaN/AlGaN/GAN P-I-N photodiodes » - D.L. Pulfrey et al - IEEE Trans. Electron Dev., 48, 486 (2001), de remplacer le matériau constituant la couche intermédiaire, par un matériau également de nature intrinsèque I, mais présentant cette fois une variation de la largeur de bande interdite, notamment pour l'application dans les détecteurs de rayonnement ultraviolet.

Une telle diode à double hétérojonction permet de favoriser la croissance des matériaux constitutifs des couches externes de dopage de type p et n, réalisées en nitrure de gallium GaN, de largeur de bande interdite plus faible que celle du matériau I, réalisé par exemple en nitrure d'aluminium et de gallium AlGaN.

Ainsi, la variation de la largeur de bande interdite dans ces structures permet de créer des barrières de potentiel pour les photoporteurs générés dans les couches n et p, limitant ainsi la détection du rayonnement à des longueurs d'onde visibles.

Ce faisant, les photoporteurs générés dans la région intermédiaire de matériau I sont principalement détectés.

Des photodiodes bi-spectrales, c'est à dire susceptibles de détecter deux types de longueurs d'onde, ont été proposées, mettant en oeuvre une triple hétéro-jonction de type P-I-i-n, dans laquelle les matériaux constitutifs des couches P et I présentent des largeurs de bande interdite plus importantes que les matériaux constitutifs des couches i et n.

Dans l'exemple décrit dans la publication H-K. Tsai et S6C. Lee, Appl. Phys. Letter, 52, 275 (1987), les matériaux constitutifs des couches I et i sont de dopage de type n, faiblement concentré, de sorte que la zone de déplétion de charges s'étend en leur sein à partir de l'interface P-I.

Les matériaux utilisés sont amorphes et présentent une mobilité et une longueur de diffusion relativement faibles, ce qui limite la collection des photoporteurs dans la zone de déplétion de charges.

La bi-spectralité est assurée par l'extension de cette zone de déplétion de charges en fonction de la polarisation inverse de la diode. Ainsi, à faible polarisation, la zone de déplétion de charges s'étend limitativement dans la couche de matériau I, sensible à des courtes valeurs de longueurs d'onde. En revanche, lorsque la polarisation est plus importante, la zone de déplétion de charges s'étend également dans la zone de matériau i, permettant ainsi de détecter un rayonnement de longueurs d'onde plus longues.

Dans le cadre de la détection multi-spectrale mettant en oeuvre des diodes multiples, deux types de montage électrique et de connexion des diodes sont utilisés.

Le premier consiste à monter les diodes du type en question en série. On a par exemple décrit dans le document US-A-5 113 076 un détecteur de rayonnement électro-magnétique, comportant deux jonctions qui fonctionnent de manière analogue à celle de deux photodiodes montées tête-bêche. Chacune des photodiodes est sensible à un rayonnement compris dans une bande spectrale infrarouge différente.

La détection d'une bande de longueurs d'onde particulière est effectuée par commutation d'une tension de polarisation. Les deux photodiodes constitutives de chacun des pixels considérés sont connectées en série et présentent une longueur d'onde de coupure différente λ₁ et λ₂.

Le principe général de cette approche consiste à créer donc deux jonctions p-n, qui collectent des photoporteurs générés dans deux matériaux semi-conducteurs présentant des largeurs de bande interdite différentes, et par conséquence, des longueurs d'onde de coupure également différentes.

Les matériaux susceptibles d'être mis en oeuvre peuvent par exemple répondre à la formule Hg₁₋ₓCdxTe, avec des compositions de cadmium différentes.

Dans la forme de réalisation décrite, la détection d'un rayonnement électromagnétique avec des longueurs d'onde ou bandes de longueurs d'onde différentes et disjointes, est possible au niveau de chaque jonction, dès lors que la jonction qui collecte les photoporteurs du matériau ayant la longueur d'onde de coupure la plus courte λ₁ est la plus proche de la source de photons. En effet, les matériaux mis en oeuvre se comportent comme des filtres passe-haut. Ainsi, une couche de matériau de longueur d'onde de coupure λ₂ absorbe toutes les longueurs d'onde inférieures à λ₂. De fait, un rayonnement comprenant par exemple deux longueurs d'onde λ₁ et λ₂, avec λ₁ < λ₂, et traversant d'abord ledit matériau de longueur d'onde de coupure λ₂ va être absorbé par celui-ci, et pratiquement aucun rayonnement de longueur d'onde λ₁ ne va aboutir à la couche de matériau de longueur d'onde de coupure λ₁. Il est donc nécessaire, afin de permettre une détection bi-spectrale, de faire pénétrer le rayonnement par la couche de matériau présentant la longueur d'onde de coupure la plus courte, puisqu'elle laisse passer toutes les longueurs d'onde supérieures.

L'inconvénient majeur lié à un tel montage en série de diodes réside dans le fait que l'architecture du circuit de lecture est complexifiée en raison du fait que les deux bandes spectrales sont détectées avec des courants en sens opposés.

Ce faisant, cela nécessite deux sites d'intégration par pixel, limitant ainsi la capacité de stockage, la capacité d'intégration, mais également la performance du détecteur en résultant, notamment pour des pas de pixels réduits.

Il a également été proposé un autre type d'architecture, mettant en oeuvre des photodiodes indépendantes, dans lesquels les diodes sont connectées électriquement de façon indépendante.

On a ainsi par exemple décrit dans le document US-A-6 034 407 un tel détecteur bi-spectral, mettant en oeuvre deux connexions par pixel, et permettant de lire les deux jonctions en même temps, donc en cohérence temporelle. Le matériau constitutif de chacune des deux jonctions p-n est choisi de telle sorte à détecter une longueur d'onde ou une bande de longueurs d'onde déterminée et disjointe de la longueur d'onde ou de la bande de longueurs d'onde détectable par la jonction adjacente du même pixel.

Cependant, le doublement des interconnexions induit une limitation du pas minimal des pixels, largement supérieure à celle des montages de diodes en série. En revanche, cette approche permet dans certain cas de limiter l'importance du gravage des matériaux constitutifs desdites diodes, et donc corollairement d'améliorer la performance des détecteurs en résultant.

Cependant et tout comme dans l'approche en série, on aboutit à une capacité de stockage limitée.

L'objectif de la présente invention est de pallier ces différents inconvénients.

### EXPOSE DE L'INVENTION

L'invention vise un photodétecteur à semi-conducteur selon la revendication 1. Ce photodétecteur est également constitué d'une diode à au moins deux hétéro-jonctions. Une telle diode à structure empilée comprend deux couches externes, respectivement une première couche de dopage de type p, et une seconde couche de dopage de type n, la largeur de la bande interdite de ces deux couches étant déterminée en fonction de l'énergie, donc de la longueur d'onde ou de la bande de longueurs d'onde qu'elles sont chacune destinées à détecter, ces deux couches étant séparées l'une de l'autre par une couche intermédiaire de même type de dopage que l'une desdites première et seconde couches, mais de largeur de bande interdite supérieure à celle de la couche en question, ledit photodétecteur étant soumis à une tension de polarisation entre les deux couches externes, de valeur réglable.

En d'autres termes, l'invention consiste à mettre en oeuvre comme photodétecteur multispectral une diode à hétéro-jonctions multiples, dont la couche intermédiaire semiconductrice joue le rôle d'interrupteur contrôlable par la tension appliquée à la diode. Autrement dit, la diode à hétéro-jonctions multiples permet la détection de deux bandes spectrales différentes, par commutation entre deux modes de détection.

Ainsi, à faible tension, la jonction constituant la diode reste localisée spatialement et n'est sensible qu'à une première longueur d'onde ou bande de longueurs d'onde. En revanche, à plus forte tension, la jonction s'étend spatialement dans ladite couche intermédiaire, présentant un dopage et une largeur de bande interdite différents, ce qui va permettre la détection d'une part, de la dite première longueur d'onde ou bande de longueurs d'onde, et d'autre part, d'une deuxième longueur d'onde ou bande de longueurs d'onde, distincte et disjointe de la première.

Selon l'invention, l'épaisseur de la couche intermédiaire est inférieure à celle des deux couches externes.

Par ailleurs, le dopage de la couche intermédiaire est de concentration inférieure à celui de chacune des couches externes.

Selon une forme de réalisation avantageuse de l'invention, la couche intermédiaire est elle-même subdivisée en plusieurs sous-couches, de même type de dopage, mais de concentrations de dopage différentes, et de largeurs de bande interdite également différentes.

L'invention permet également la détection de rayonnement électromagnétique multispectral, c'est à dire intégrant plus de deux longueurs d'onde ou bandes de longueurs d'onde. Ainsi, pour la détection de trois longueurs d'onde ou bandes de longueurs d'onde, le photodétecteur met en oeuvre deux diodes à hétéro-jonctions multiples en série du type de celles précédemment décrites.

La mise en oeuvre d'une telle architecture permet également la détection de quatre longueurs d'onde ou bandes de longueurs d'onde différentes, selon le même principe.

L'invention concerne également un dispositif de détection multispectral de rayonnement électromagnétique, qui consiste à mettre en oeuvre une matrice des photodétecteurs du type de ceux précédemment décrits.

Elle concerne enfin un procédé de mise en oeuvre du dispositif de détection multi-spectral en question. Celui-ci consiste :
- à appliquer une première tension pour détecter les photoporteurs créés dans la couche externe de dopage opposé à celui de la couche intermédiaire ;
- puis, à appliquer une seconde tension, de valeur plus élevée que celle de ladite première tension, afin de détecter les photoporteurs créés dans les deux couches externes ;
- et enfin, à soustraire les deux quantités ainsi obtenues pour déterminer le nombre de photoporteurs créés par la seconde couche externe.

La manière de réaliser l'invention et les avantages qui en découlent ressortiront mieux des exemples de réalisation qui suivent, donnés à titre indicatif et non limitatif à l'appui des figures annexées.

### BREVE DESCRIPTION DES FIGURES

La figure 1 est une représentation schématique en section d'une partie matricielle d'un photodétecteur multispectral conforme à l'invention.
Les figures 2a et 2b représentent la variation pour un photodétecteur du type de celui de la figure 1, respectivement de la densité de conducteurs et de la largeur de bande interdite, en fonction de la localisation de la mesure de ces grandeurs par rapport à l'hétéro-jonction mise en oeuvre dans le cadre de la présente invention.
La figure 3 est un graphe représentatif de la densité de courant résultant de la détection par un photodétecteur conforme à l'invention d'un rayonnement électromagnétique, selon deux valeurs de tension appliquée au photodétecteur, et en fonction de la longueur d'onde.
La figure 4 est une représentation schématique en section d'un autre photodétecteur conforme à l'invention.
La figure 5a et 5b sont des graphes analogues à ceux des figures 2a et 2b, mais en relation avec le photodétecteur de la figure 4.
Les figures 6 et 7 sont des représentations schématiques en section d'autres formes de réalisation de l'invention, respectivement pour une détection tri-spectrale et quadri-spectrale.

### DESCRIPTION DETAILLEE DE L'INVENTION

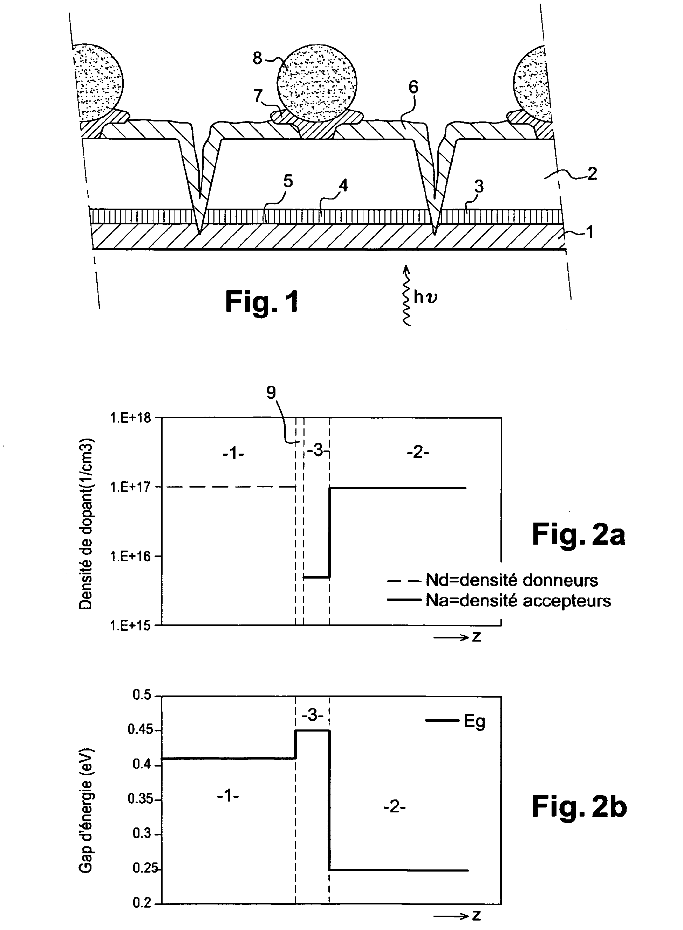

La figure 1 illustre une partie d'un détecteur bi-spectral de type photovoltaïque. Ce détecteur est de nature matricielle, chacun des pixels de ladite matrice étant constitué d'une photodiode présentant deux hétéro-jonctions.

Chaque diode comporte tout d'abord deux couches externes (1) et (2) réalisées en un matériau semi-conducteur de dopage et de largeur de bande interdite différents. Dans l'exemple décrit, la couche (1) la plus proche de la source de rayonnement est dopée n, et l'autre couche (2) est dopée p.

Les deux couches (1) et (2) sont séparées par un troisième couche (3), dite couche intermédiaire, également réalisée en un matériau semi-conducteur, et de même type de dopage que la couche (2). Ce faisant, une jonction p-n est formée à l'interface (5) définie au niveau de la zone de contact entre la couche intermédiaire (3) et la couche (1). Le niveau de dopage de la couche intermédiaire (3) est plus faible que celui de la couche (2), de sorte que la zone de charge d'espace s'étend principalement au sein de ladite couche (3).

La largeur de la bande interdite de la couche intermédiaire (3) est supérieure à celle de la couche (2), afin de former une barrière de potentiel à l'interface (5).

Les différentes couches constitutives de la photodiode de l'invention sont, de préférence, réalisées par épitaxie, par exemple par jet moléculaire. Les pixels constitutifs du circuit de détection sont réalisés sous la forme de mesa, qui permet de délimiter la collecte des photo-porteurs dans la structure mesa.

L'isolation électrique de chacun des pixels par rapport aux pixels adjacents est réalisée par gravure des mesa. De plus, une protection mécanique et électrique est obtenue au moyen d'une couche (6) en matériau isolant, recouvrant partiellement chacun des mesa constitutifs desdits pixels, et dont l'extrémité aboutit au sein de la couche la plus externe (1) du substrat de base.

En partie supérieure des mesa, un contact électrique avec la couche (2) est réalisé au moyen d'un conducteur (7), permettant ensuite l'hybridation du circuit de détection constitué par une telle matrice de photodétecteurs sur un circuit de lecture au moyen de microbilles d'indium (8). Cette technologie est bien connue de l'homme du métier, de sorte qu'il n'y a pas lieu de la décrire ici plus en détail.

Chaque photodétecteur est donc muni de deux connexions : la microbille (8) et un contact réalisé en face arrière du substrat. Entre ces deux bornes, sont connectés de façon classique le circuit de polarisation, le circuit de mesure du courant créé par les photoporteurs, etc.

L'exemple de photodiode illustrée au sein de la figure 1 est du type N-P-p. Il est sous-entendu que l'invention concerne également la configuration inverse P-N-n.

Chaque photodiode permet de détecter un rayonnement incident dans deux bandes de longueurs d'onde différentes par la mise en oeuvre de deux modes différents. Un premier mode détecte le rayonnement absorbé dans la couche (1) dans une bande de longueur d'onde B₁=Δλ₁. Un deuxième mode permet la détection du rayonnement incident absorbé dans les couches (1) et (2) correspondant à une bande de longueurs d'onde B₁₋₂ = Δλ₁+Δλ₂.

La commutation entre les modes s'effectue par l'extension de la zone de charge d'espace de la jonction p-n à travers la barrière de potentiel formée à l'hétérojonction entre les couches (2) et (1). La fonction de cette barrière de potentiel est de repousser les photo porteurs générés dans la couche (2) et ainsi d'empêcher la détection des rayonnements dans la bande de longueurs d'onde Δλ₂ lorsque la photodiode fonctionne en mode 1.

Les figures 2a et 2b illustrent un exemple typique de dopages et de largeurs de bande interdite en fonction de la position dans la structure de la photodiode.

L'épaisseur de la couche intermédiaire (3) est choisie telle que la zone de charge d'espace (9) s'étende seulement partiellement au travers de ladite couche (3) pour des valeurs de polarisation inverse V faible (mode 1). Lorsque la photodiode est soumise à une tension de polarisation inverse suffisante (mode 2), la zone de charge d'espace s'étend dans la couche intermédiaire (3) jusqu'au niveau de la couche (2), permettant ainsi aux photoporteurs générés dans la couche (2) suite à l'absorption du rayonnement incident de franchir la barrière de potentiel et ainsi contribuer au photo courant. L'ajustement de cette tension de polarisation inverse V permet ainsi d'obtenir deux modes de fonctionnement :
- mode 1 : V<Vs : le photo courant est dominé par les photo-porteurs générés dans la couche (1) de dopage de type opposé à celui de la couche intermédiaire (3). Les porteurs générés dans la couche (2) sont repoussés de la jonction p-n par la barrière de potentiel formée à l'interface (5) entre la couche (2) et la couche intermédiaire (3), selon un principe connu de la technologie des semi-conducteurs. Les photo-porteurs générés dans la couche (2) ne sont par conséquent pas collectés. Dans l'exemple de réalisation illustré au sein des figures 2a et 2b, le pixel de la figure 1 détecte limitativement dans ce mode 1 les longueurs d'onde λ<λ_{c1} ;
- mode 2 : V>Vs: l'extension de la zone de déplétion jusqu'à la couche (2) permet aux photo porteurs de franchir la barrière de potentiel située à l'interface (5) et donc de collecter les photo porteurs générés dans cette couche. Ainsi, dans ce mode, le rayonnement incident est détecté dans les deux bandes de longueurs d'onde B₁ (λ<λ_{c1}) et B₂ (λ_{c1}<λ<λ_{c2}). La contribution de la bande B₂ peut être obtenue par soustraction de la contribution de la bande B₁, mesurée en mode 1.

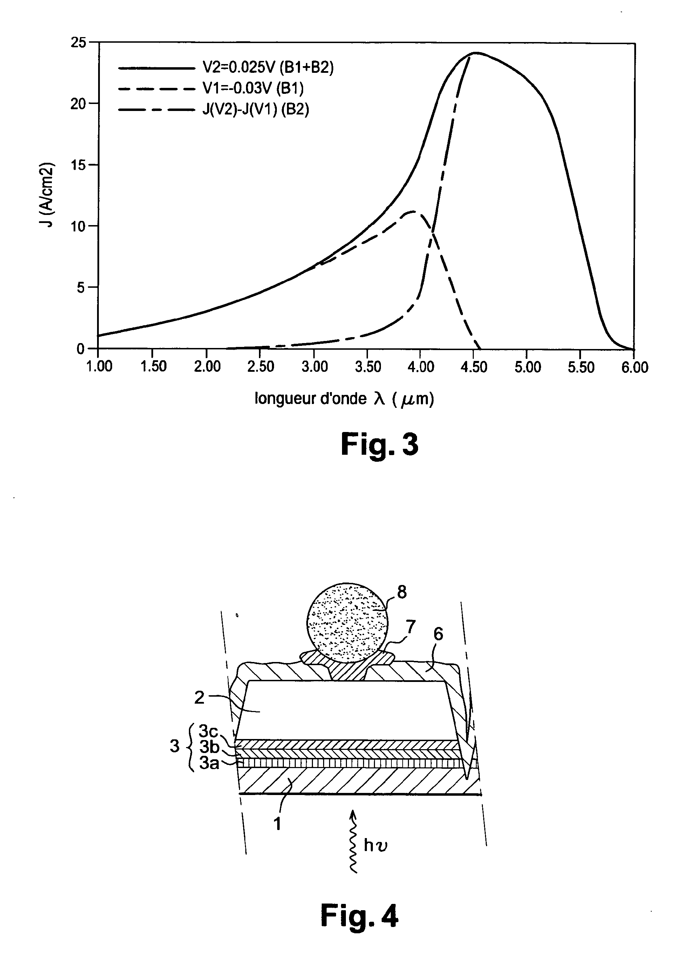

La figure 3 illustre un exemple de réponse spectrale pour un photo-détecteur intégrant une jonction selon l'invention :
- pour V = 0.03 Volt, le détecteur fonctionne en mode 1 et le rayonnement incident est détecté pour Δλ₁<λ_{c1} ;
- pour V = 0.25Volt, le détecteur fonctionne en mode 2, et détecte le rayonnement λ<λc₂ ;
- La contribution de la bande Δλ_{c2}, λ_{c1} <λ<λ_{c2} est estimée par soustraction de la réponse en mode 1 et mode 2.

L'invention se différencie de l'état antérieur de la technique par la combinaison des variations de dopages et de largeurs de bande interdite, qui assurent le fonctionnement de la diode en question, E_{g2}<E_{g1}≤E_{g3} et |N₃ |< |N₂| et |N₃ |< |N₁|, ainsi que par l'épaisseur des différentes couches.

Le dopage de la couche intermédiaire (3) est ajusté de telle sorte que la zone de charge d'espace ne s'étende que partiellement au travers de celle-ci. Ce faisant, et contrairement aux enseignements de l'état antérieur de la technique, cette zone de charge d'espace est localisée à une interface pour des faibles valeurs de tension de polarisation.

L'absorption du rayonnement s'effectue dans les couches (1) et (2), externes par rapport à cette couche intermédiaire (3). L'épaisseur de cette dernière est plus faible que celle de ces deux couches (1, 2). Dans les structures traditionnelles de type p-i-n, le rayonnement est détecté dans la région i, qui est alors plus épaisse qu'au moins l'une des deux couches externes.

Les niveaux de dopage sont en outre choisis de telle sorte que la barrière de potentiel générée à l'interface (5) soit placée en dehors de la zone de charge d'espace pour des faibles valeurs de la tension de polarisation.

Dans un deuxième exemple de réalisation, le mode 1 détecte seulement la bande B₂ λ_{c1}<λ<λ_{c2}. Le mode 2 détecte toujours dans les deux bandes et la contribution de la bande B₁ est encore obtenue par soustraction.

Dans encore un autre exemple de réalisation de l'invention, tel qu'illustré au sein de la figure 4, la couche intermédiaire (3) est subdivisée en plusieurs sous-couches, trois en l'espèce (3a, 3b, 3c) présentant des niveaux de dopage et de largeur de bande interdite différents.

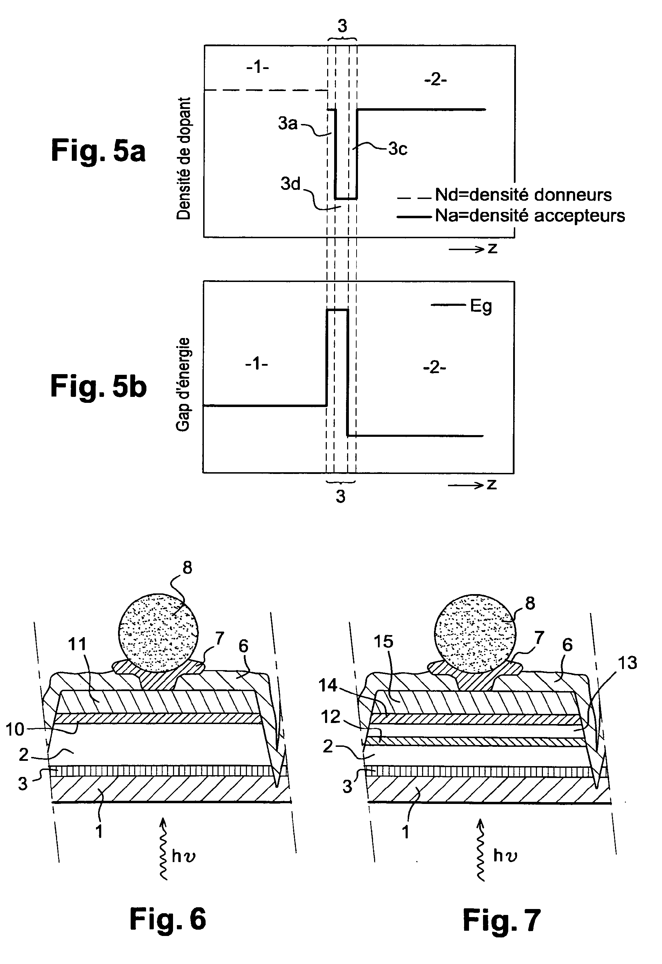

Les figures 5a et 5b illustrent des exemples typiques de dopages et de largeurs de bande interdite en fonction de la position dans la structure:

Ainsi, le niveau ou concentration de dopage le plus important est situé dans la zone (3a), c'est à dire dans la sous-couche en contact avec la couche externe (1) de dopage de type opposé à son propre type de dopage. Ce faisant, on limite l'extension spatiale de la zone de déplétion pour des valeurs faibles de tension de polarisation inverse. Cette limitation va donner une commutation qui est moins dépendante du dopage dans les zones de dopage faible, (3b) et (3c). La limitation de l'extension spatiale de la zone de déplétion peut également réduire le courant de fuite de la couche (2) à travers la barrière de potentiel.

La présence de la zone (3a) permet aussi de moduler le dopage dans les zones (3b) et (3c) dans une plus grande latitude, ce qui permet d'obtenir une commutation entre les modes pour une valeur de seuil de la tension de polarisation Vs plus faible.

Enfin, la zone (3c) agit comme un zone de courbure de bande permettant de franchir la barrière de potentiel au niveau de l'interface entre les zones (3b) et (3c) à une valeur de polarisation plus faible. Ce faisant, la diode peut fonctionner de manière plus stable, les fuites électriques possibles étant alors limitées, étant rappelé que lesdites fuites augmentent avec la tension de polarisation.

Les essais réalisés montrent qu'avec un photo-détecteur réalisé au moyen de photo-diodes conformes à la figure 4, la commutation pour la sélection des bandes spectrales est plus sensible à la polarisation, et en outre la valeur de la tension seuil de polarisation est plus faible que pour un détecteur mettant en oeuvre des photo-diodes conformes à la figure 1.

Au regard des améliorations de performance décrites ci-dessus, la mise en oeuvre d'un détecteur intégrant au moins trois zones au niveau de la couche intermédiaire (3) permet d'obtenir une commutation plus stable par rapport aux fluctuations des paramètres des différentes couches. De plus, les épaisseurs desdites couches, leur niveau de dopage et la largeur de leur bande interdite peuvent être optimisés en fonction de l'application et les bandes de longueurs d'onde à détecter.

Un détecteur de rayonnement électromagnétique conforme à l'invention comprend donc une matrice de pixels constitué chacun d'une photo-diode du type de celle décrite en relation avec la figure 1 ou la figure 4. Les pixels sont séparés physiquement les uns des autres pour éviter tout court-circuit électrique entre les diodes qui les constituent, et afin que la collecte de chaque jonction puisse être localisée. Ceci explique en partie la gravure desdits pixels en forme de mesa.

La mise en oeuvre d'une connexion des diodes en série permet d'utiliser une seule interconnexion par pixel pour relier électriquement le circuit de détection au circuit de lecture. Ce faisant, une densité maximum de pixels peut être obtenue et limitée par la seule densité d'interconnexion.

La figure 6 illustre la structure d'un détecteur tri-spectral conformément à l'invention. Celui-ci est constitué de deux diodes à hétéro jonctions multiples du type de celle décrite ci-dessus, et montées en configuration série.

En fonction du signe de polarisation de la tension qui lui est appliquée, l'une des deux diodes est polarisée en inverse et peut détecter un rayonnement incident. Le détecteur tri spectral est capable de mesurer le rayonnement incident dans trois bandes spectrales différentes, par exemple B₁ (λ<λ_{c1}), B₂ (λ_{c1}<λ<λ_{c2}) et B₃ (λ_{c2}<λ<λ_{c3}).

Chaque bande spectacle est associée avec une couche collectrice ; ainsi, la bande B₁ est associée avec la couche (1), la bande B₂ avec la couche (2), et la bande B₃ avec la couche (11). Les couches (1) et (11) associées avec les bandes B₁ et B₃ sont de même type de dopage, opposé à celui de la couche (2) associé avec la bande B₂.

Les couches collectrices (1, 2, 11) sont séparées par des couches intermédiaires (3) et (10) respectivement, afin de constituer des hétéro-jonctions multiples, destinées à permettre la commutation des diodes formées respectivement entre les couches (1) et (2), et (2) et (11) entre les deux modes de fonctionnements caractéristiques de l'invention.

Quatre modes de lecture sont possibles en fonction de la polarisation des diodes, par exemple :
Diode (1)-(2) polarisée en inverse :
   - Mode 1₁₋₂ : détection dans la bande B₁
   - Mode 2₁₋₂ : détection dans les bandes B₁ + B₂
Diode (2)-(11) polarisée en inverse :
   - Mode 1₂₋₁₁ : détection dans la bande B₂
   - Mode 2₂₋₁₁ : détection dans les bandes B₂ + B₃

L'estimation du rayonnement détecté dans la bande B₃ peut être obtenu par soustraction de la contribution de la bande B₂, mesurée en Mode 1.

Le circuit de lecture tri-spectral est de préférence réalisé par croissance par épitaxie des différentes couches mises en oeuvre et par gravure jusque dans la couche externe (1) pour délimiter la collecte des photo-porteurs dans chaque pixel.

La figure 7 illustre la structure d'un détecteur quadri spectral conformément à l'invention. Celui-ci est constitué de deux diodes à hétéro-jonctions multiples du type de celles décrites en relation avec les figures 1 à 5, lesdites diodes étant montées en série.

Ce détecteur quadri-spectral est susceptible de mesurer un rayonnement incident selon quatre bandes spectrales différentes, par exemple B₁ (λ<λ_{c1}), B₂ (λ_{c1}<λ<λ_{c2}), B₃ (λ_{c2}<λ<λ_{c3}) et B₄ (λ_{c3}<λ<λ_{c4}).

Chaque bande spectacle est associée avec une couche collectrice ; la bande B₁ est associée avec la couche (1), la bande B₂ est associée avec la couche (2), la bande B₃ est associée avec la couche (13), et la bande B₄ est associée avec la couche (15).

Les couches collectrices (1) et (15) associées avec les bandes B₁ et B₄ sont de même type de dopage, opposé à celui des couches collectrices (2, 13) associées aux couches B₂ et B₃.

Des couches intermédiaires de séparation (3) et (14), formées d'au moins une couche en un matériau semi-conducteur, rendent commutables les diodes constituées entre les couches (1) et (2) et entre les couches (13) et (14) entre les deux modes de fonctionnement caractéristiques de l'invention.

Les couches (2) et (13) sont séparées par une couche barrière (12) de même type de dopage que lesdites couches (2, 13), afin d'isoler la collecte de photo-porteurs dans les deux régions qu'elle sépare.

Quatre modes de lecture sont ainsi obtenus en fonction de la tension de polarisation appliquée, et par exemple :
Diode (1)-(2) polarisée en inverse :
   - Mode 1₁₋₂ : détection de la bande B₁
   - Mode 2₁₋₂ : détection des bandes B₁ + B₂
Diode (13)-(15) polarisée en inverse :
   - Mode 1₁₃₋₁₅ : détection de la bande B₃
   - Mode 2₁₃₋₁₅ : détection des bandes B₃ + B₄

Il peut être remarqué que les modes x₁₃₋₁₅ sont obtenus par inversion de la tension de polarisation par rapport aux modes x₁₋₂.

L'estimation du rayonnement détecté dans la bande B₄ et B₂ peut être obtenue par soustractions des contributions des bandes B₁ et B₃, mesurées en modes 1.

Ces réalisations tri- et quadri-spectrales réalisées conformément à l'invention permettent de ne nécessiter qu'une seule interconnexion électrique par pixel (par exemple la microbille (8)- le contact électrique en face arrière du substrat ne comptant pas), et ce, contrairement aux dispositifs de l'état antérieur de la technique, dans lesquels au moins deux, voire trois connexions par pixel sont nécessaires.

D'autres structures de type diodes en série entrent dans le champ de l'invention pour la réalisation de détecteurs tri- et quadri- spectraux., telles que par exemple les jonctions commutables selon l'invention en configuration n-p-n.

Le matériau semi-conducteur utilisé dans l'invention peut, par exemple, être constitué de Hg₁₋ₓCdₓTe. D'autres exemples de matériaux utilisables pour les détecteurs de l'invention appartiennent à la famille des semi-conducteurs III - V (InAs₁₋ₓSbx, Ga₁₋ₓInₓAs_{1-y}Sb_{y}) ou à la famille des semi-conducteurs de type IV - VI (Pb₁₋ₓSnₓTe ou Pb₁₋ₓSnₓSe).

Pour ces différents composés, la largeur de la bande interdite et la longueur d'onde de coupure peuvent être ajustées par la composition. Dans Hg₁₋ₓCdₓTe à 77 K, des compositions x = 0.225 et x = 0.3 donnent des gap d'énergie Eg = 0,12 eV et Eg = 0,24 eV, correspondant à des longueurs d'onde de coupure de λc = 10µm et λc = 5.1µm, respectivement.

La barrière de potentiel peut, dans le cas de Hg₁₋ₓCdₓTe, présenter une largeur de bande interdite de Eg>0.6eV correspondant à une composition de Cd de x>0.52.

Le circuit de détection quadri-spectral est de préférence réalisé par croissance par épitaxie des couches et par gravure pour délimiter la collecte des photo-porteurs dans chaque pixel. La gravure doit être réalisée à travers la couche intermédiaire (3).

L'invention permet de simplifier de manière importante l'électronique nécessaire au niveau du circuit de lecture pour un nombre de couleurs, ou de longueurs d'onde données, par rapport à l'état antérieur de la technique.

L'invention permet également la réalisation de manière simple de photo-détecteurs jusqu'au quadri spectral, avec une interconnexion par pixel et un circuit de lecture simplifié.

## Revendications

1. Photo-détecteur à semi-conducteur constitué d'une diode à au moins deux hétéro-jonctions comprenant deux couches externes (1, 2), respectivement une première couche (1) de type de dopage donné, et une seconde couche (2) de type de dopage opposé au type de dopage de la première couche (1), chacune de ces deux couches étant choisie de sorte qu'elles ont chacune une certaine largeur de bande interdite, lesdites largeurs des bandes interdites étant déterminées en fonction de l'énergie, donc de la longueur d'onde ou de la bande de longueurs d'onde que les deux couches sont chacune destinées à détecter, ces deux couches étant séparées l'une de l'autre par une couche intermédiaire (3) de même type de dopage que l'une desdites première et seconde couches, le photo-détecteur comprenant un circuit apte à soumettre ladite diode à une tension de polarisation de valeur réglable entre les deux couches externes (1) et (2), ***caractérisé* :**
- **en ce que** la largeur de la bande interdite de la couche externe (1) de type de dopage opposé à celui de la couche intermédiaire (3) est supérieure à celle de la couche externe (2) de même type de dopage que celui de la couche intermédiaire (3) et est inférieure ou égale à celle de la couche intermédiaire (3) ;
- **en ce que** le dopage de la couche intermédiaire (3) est de concentration inférieure à celui de chacune des couches externes (1, 2) ;
- **en ce que** l'épaisseur de la couche intermédiaire (3) est inférieure à celle des deux couches externes (1, 2) ; et
- **en ce que** l'épaisseur et le dopage de la couche intermédiaire (3) sont choisis de manière à ce que :
• pour des valeurs de tension de polarisation inverse entre les deux couches externes (1,2) inférieures à une valeur de tension prédéterminée, la zone de charge d'espace résultante ne s'étende que partiellement au travers de la couche intermédiaire (3); et
• pour des valeurs de tension de polarisation inverse entre les deux couches externes (1, 2) supérieures à la valeur de tension prédéterminée, la zone de charge d'espace résultante s'étende jusqu'à la couche externe (2) de même type de dopage que celui de la couche intermédiaire (3).

2. Photo-détecteur à semi-conducteur la revendication 1, ***caractérisé* en ce que** la couche intermédiaire (3) est elle-même subdivisée en plusieurs sous-couches (3a, 3b, 3c), de même type de dopage, mais de concentrations de dopage différentes, et de largeurs de bande interdite également différentes.

3. Photo-détecteur à semi-conducteur selon la revendication 2, ***caractérisé* en ce que** la concentration de dopage la plus importante desdites sous-couches (3a, 3b, 3c) est située dans la sous-couche (3a) en contact avec la couche externe (1) de type de dopage opposé à son propre dopage.

4. Photo-détecteur à semi-conducteur pour réaliser la détection multi-spectrale d'un rayonnement électromagnétique, ***caractérisé* en ce qu'**il est constitué par le montage en série de deux diodes à hétéro-jonctions multiples selon l'une des revendications 1 à 3, et mettant en oeuvre trois couches (1, 2, 11) de collecte des photons constitutifs du rayonnement incident, dont les deux couches les plus externes (1, 11) présentent le même type de dopage, opposé au type de dopage de la couche centrale (2), la commutation entre les deux modes de fonctionnement de chacune desdites diodes à hétéro jonctions, respectivement (1, 2) et (2, 11) étant rendue possible par l'intercalation entre les deux couches constitutives desdites diodes d'une couche intermédiaire (3) et (10) respectivement.

5. Photo-détecteur à semi-conducteur pour réaliser la détection multi-spectrale d'un rayonnement électromagnétique, ***caractérisé* en ce qu'**il est constitué par le montage en série de deux diodes à hétérojonctions multiples selon l'une des revendications 1 à 3, et mettant en oeuvre quatre couches de collecte (1, 2, 13, 15) des photons constitutifs du rayonnement incident, dont les deux couches les plus externes (1, 15) présentent le même type de dopage, opposé au type de dopage des couches centrales (2, 13), la commutation entre les deux modes de fonctionnement de chacune desdites diodes à hétéro jonctions, respectivement (1, 2) et (13, 15) étant rendue possible par l'intercalation entre les deux couches constitutives desdites diodes d'une couche intermédiaire (3) et (14) respectivement, les couches collectrices centrales (2, 13) étant en outre séparées par une couche barrière (12) de même type de dopage que lesdites couches (2, 13), afin d'isoler la collecte des photo-porteurs dans les deux régions qu'elle sépare.

6. Dispositif de détection multispectral de rayonnement électromagnétique, ***caractérisé* en ce qu'**il comprend une matrice de pixels constitués chacun d'un photodétecteur selon l'une des revendications 1 à 5.

7. Dispositif de détection multispectral de rayonnement électromagnétique selon la revendication 6, ***caractérisé* en ce que** lesdits pixels sont connectés à un circuit de lecture par hybridation au moyen de microbilles d'indium (8).

8. Procédé pour la mise en oeuvre d'un dispositif de détection multi-spectral intégrant des photodétecteurs selon l'une des revendications 1 à 3, ***caractérisé* en ce qu'**il consiste :
• à appliquer une première tension audit dispositif pour détecter les photoporteurs créés dans la couche externe de type de dopage différent ou opposé à celui de la couche intermédiaire (3) ;
• puis, à appliquer une seconde tension, de valeur plus élevée que celle de ladite première tension, afin de détecter les photoporteurs créés dans les deux couches externes (1, 2) ;
• et enfin, à soustraire les deux quantités ainsi obtenues pour déterminer le nombre de photoporteurs créés par la seconde couche externe.

## Claims

1. A semiconductor photodetector consisting of a diode with at least two heterojunctions comprising two external layers (1, 2), a first layer (1) with a given kind or type of doping and a second layer (2) with a kind or type of doping opposite to that of the first layer (1) respectively, each of said two layers being chosen in regard of their respective bandgap width, said bandgap widths being determined as a function of the energy and hence the wavelength or wavelength band that both layers are each intended to detect, these two layers being separated from each other by an intermediate layer (3) having the same kind or type of doping as one of said first and second layers, said diode being subjected to a bias voltage of adjustable value between the two external layers (1) and (2), ***characterised* :**
• **in that** the bandgap width of the external layer (1) of doping opposite to that of the intermediate layer (3) is greater than that of the external layer (2) of same type of doping as that of intermediate layer (3), et is less or equal to that of intermediate layer (3) ;
• **in that** the doping of the intermediate layer (3) is less than that of each of the external layers (1, 2) ;.
• **in that** that the thickness of the intermediate layer (3) is less than that of the two external layers (1, 2), and
• the thickness and the doping of the intermediate layer (3) are selected so that :
- for reverse bias voltage between the two external layers (1, 2) less than a predeterrmined value, the resulting space charge area only partially extends through the intermediate layer (3) ;
- for reverse bias voltage between the two external layers (1, 2) greater than said predetermined value, the resulting space charge area extends till the external layer (2) of same type of doping than that of intermediate layer (3).

2. A semiconductor photodetector as claimed in claim 1, ***characterised* in that** the intermediate layer (3) is itself subdivided into several sub-layers (3a, 3b, 3c) having the same type of doping but different doping concentrations and different bandgap widths.

3. A semiconductor photodetector as claimed in claim 2, ***characterised* in that** the highest doping concentration of said sub-layers (3a, 3b, 3c) is located in sub-layer (3a) that is in contact with external layer (1) having a kind or type of doping that is opposite to that of sub-layer (3a).

4. A semiconductor photodetector for obtaining multispectrum detection of electromagnetic radiation, ***characterised* in that** it consists of a series-connected arrangement of two multiheterojunction diodes as claimed in any of claims 1 to 3 and uses three layers (1, 2, 11) to collect photons that constitute the incident radiation, the two outermost layers (1, 11) having the same kind or type of doping that is opposite to the type of doping of middle layer (2), switching between the two operating modes of each of said heterojunction diodes (1, 2) and (2, 11) respectively being made possible by inserting an intermediate layer (3) and (10) respectively between the two layers that constitute said diodes.

5. A semiconductor photodetector for obtaining multispectrum detection of electromagnetic radiation, ***characterised* in that** it consists of a series-connected arrangement of two multiheterojunction diodes as claimed in any of claims 1 to 3 and uses four layers (1, 2, 13, 15) to collect photons that constitute the incident radiation, the two outermost layers (1, 15) having the same kind or type of doping that is opposite to the type of doping of the middle layers (2, 13), switching between the two operating modes of each of said heterojunction diodes (1, 2) and (13, 15) respectively being made possible by inserting an intermediate layer (3) and (14) respectively between the two layers that constitute the diodes, middle collector layers (2, 13) being also separated by a barrier layer (12) having the same type of doping as said layers (2, 13) in order to isolate the collection of photo carriers in the two areas that it separates.

6. A multispectrum electromagnetic radiation detection device, ***characterised* in that** it comprises an array of pixels each consisting of a photodetector as claimed in any of claims 1 to 5.

7. A multispectrum electromagnetic radiation detection device as claimed in claim 6, ***characterised* in that** said pixels are connected to a read-out circuit by means of hybridisation using indium beads (8).

8. A method for using a multispectrum detection device that contains photodetectors as claimed in any of claims 1 to 3, ***characterised* in that** it involves:
• applying a first voltage to said device in order to detect the photo carriers created in the external layer that is differently or oppositely doped to the intermediate layer (3);
• then applying a second voltage having a value higher than that of said first voltage in order to detect the photo carriers created in the two external layers (1, 2);
• and, finally, subtracting the two quantities thus obtained in order to determine the number of photo carriers created by the second external layer.

## Patentansprüche

1. Halbleiter-Photodetektor, der aus einer Diode mit mindestens zwei Heteroübergängen besteht, die zwei äußere Schichten (1, 2) umfasst, eine erste Schicht (1) eines bestimmten Dotierungstyps bzw. eine zweite Schicht (2) eines zum Dotierungstyp der ersten Schicht (1) entgegen gesetzten Dotierungstyps, wobei jede der Schichten so ausgewählt ist, dass sie jeweils eine bestimmte Sperrbandbreite haben, wobei die Breiten der Sperrbänder in Abhängigkeit von der Energie, also der Wellenlänge oder des Wellenlängenbands bestimmt sind, die die beiden Schichten jeweils zu erfassen bestimmt sind, wobei die beiden Schichten durch eine Zwischenschicht (3) desselben Dotierungstyps wie eine der Schichten, der ersten oder zweiten Schicht, voneinander getrennt sind, wobei der Photodetektor eine Schaltung umfasst, die die Diode mit einer Polarisierungsspannung mit regelbarem Wert zwischen den beiden äußeren Schichten (1) und (2) beaufschlagen kann, **dadurch gekennzeichnet, dass**:
- die Sperrbandbreite der äußeren Schicht (1) des zu demjenigen der Zwischenschicht (3) entgegen gesetzten Dotierungstyps größer ist als diejenige der äußeren Schicht (2) des Dotierungstyps, der gleich demjenigen der Zwischenschicht (3) ist, und kleiner oder gleich als diejenige der Zwischenschicht (3) ist;
- die Dotierung der Zwischenschicht (3) von geringerer Konzentration ist als diejenige jeder der äußeren Schichten (1, 2);
- die Dicke der Zwischenschicht (3) geringer ist als diejenige der beiden äußeren Schichten (1, 2); und
- die Dicke und die Dotierung der Zwischenschicht (3) so gewählt sind, dass:
• für Spannungswerte einer umgekehrten Polarisation zwischen den beiden äußeren Schichten (1, 2), die kleiner sind als ein vorbestimmter Spannungswert, die sich ergebende Raumladungszone sich nur teilweise über die Zwischenschicht (3) erstreckt; und
• für Spannungswerte einer umgekehrten Polarisation zwischen den beiden äußeren Schichten (1, 2), die größer sind als der vorbestimmte Spannungswert, die sich ergebende Raumladungszone sich bis zur äußeren Schicht (2) desselben Dotierungstyps wie desjenigen der Zwischenschicht (3) erstreckt.

2. Halbleiter-Photodetektor nach Anspruch 1, **dadurch gekennzeichnet, dass** die Zwischenschicht (3) wiederum in mehrere Teilschichten (3a, 3b, 3c) desselben Dotierungstyps aber mit unterschiedlichen Dotierungskonzentrationen und ebenfalls unterschiedlichen Sperrbandbreiten unterteilt ist.

3. Halbleiter-Photodetektor nach Anspruch 2, **dadurch gekennzeichnet, dass** sich die höchste Dotierungskonzentration der Teilschichten (3a, 3b, 3c) in der Teilschicht (3a) befindet, die mit der äußeren Schicht (1) des zu ihrer eigenen Dotierung entgegen gesetzten Dotierungstyps in Kontakt ist.

4. Halbleiter-Photodetektor zum Durchführen einer multispektralen Erfassung einer elektromagnetischen Strahlung, **dadurch gekennzeichnet, dass** er aus einer Reihenschaltung zweier Dioden mit mehreren Heteroübergängen nach einem der Ansprüche 1 bis 3 besteht und drei Kollektorschichten (1, 2, 11) für die Photonen einsetzt, die die einfallende Strahlung bilden, deren beide äußerste Schichten (1, 11) denselben Dotierungstyp aufweisen, der entgegengesetzt zum Dotierungstyp der mittleren Schicht (2) ist, wobei die Umschaltung zwischen den beiden Funktionsarten jeder der Dioden mit Heteroübergängen, (1, 2) bzw. (2, 11), durch Einfügen einer Zwischenschicht (3) bzw. (10) zwischen die beiden, die Dioden bildenden Schichten ermöglicht ist.

5. Halbleiter-Photodetektor zum Durchführen einer multispektralen Erfassung einer elektromagnetischen Strahlung, **dadurch gekennzeichnet, dass** er aus einer Reihenschaltung zweier Dioden mit mehreren Heteroübergängen nach einem der Ansprüche 1 bis 3 besteht und vier Kollektorschichten (1, 2, 13, 15) für die Photonen einsetzt, die die einfallende Strahlung bilden, deren beide äußerste Schichten (1, 15) denselben Dotierungstyp aufweisen, der entgegengesetzt zum Dotierungstyp der mittleren Schichten (2, 13) ist, wobei die Umschaltung zwischen den beiden Funktionsarten jeder der Dioden mit Heteroübergängen, (1, 2) bzw. (13, 15), durch Einfügen einer Zwischenschicht (3) bzw. (14) zwischen die beiden, die Dioden bildenden Schichten ermöglicht ist, wobei die mittleren Kollektorschichten (2, 13) darüber hinaus durch eine Sperrschicht (12) desselben Dotierungstyps wie die Schichten (2, 13) getrennt sind, um die Erfassung der Phototräger in den beiden Bereichen, die sie trennt, voneinander zu isolieren.

6. Vorrichtung zur multispektralen Erfassung elektromagnetischer Strahlung, **dadurch gekennzeichnet, dass** sie eine Matrix von Pixeln umfasst, die jeweils aus einem Photodetektor nach einem der Ansprüche 1 bis 5 bestehen.

7. Vorrichtung zur multispektralen Erfassung elektromagnetischer Strahlung nach Anspruch 6, **dadurch gekennzeichnet, dass** die Pixel durch Hybridierung mittels Mikrokügelchen aus Indium (8) mit einer Leseschaltung verbunden sind.

8. Verfahren zum Einsetzen einer Vorrichtung zur multispektralen Erfassung, in die Photodetektoren nach einem der Ansprüche 1 bis 3 integriert sind, **dadurch gekennzeichnet, dass** es darin besteht:
• eine erste Spannung an die Vorrichtung anzulegen, um die Phototräger zu erfassen, die in der äußeren Schicht des Dotierungstyps, der zu demjenigen der Zwischenschicht (3) unterschiedlich oder entgegengesetzt ist, entstanden sind;
• dann eine zweite Spannung mit höherem Wert als die erste Spannung anzulegen, um die Phototräger zu erfassen, die in den beiden äußeren Schichten (1, 2) entstanden sind;
• und schließlich die beiden so erhaltenen Mengen zu subtrahieren, um die Anzahl der durch die zweite äußere Schicht entstandenen Phototräger zu bestimmen.
